# EUROPÄISCHE PATENTSCHRIFT

(11) **EP 3 381 020 B1**
(45) Veröffentlichungstag und Bekanntmachung des Hinweises auf die Patenterteilung: **19.06.2024**
(21) Anmeldenummer: 16795367.8
(22) Anmeldetag: 15.11.2016
(51) Int. Cl.: G08B 13/00, G08B 17/00, G08B 17/10, G08B 25/01, G08B 25/04, G08B 25/14, G08B 29/14, G08B 29/26, G08B 26/00

(54) **VERFAHREN ZUM BESTIMMEN VON SCHWELLENWERTEN EINER ZUSTANDSÜBERWACHUNGSEINHEIT FÜR EINE BRANDMELDER- UND/ODER LÖSCHSTEUERZENTRALE SOWIE ZUSTANDSÜBERWACHUNGSEINHEIT UND SYSTEM DAMIT**
METHOD FOR DETERMINING THRESHOLDS OF A STATE MONITORING UNIT FOR A FIRE DETECTION AND/OR EXTINGUISHING CONTROL CENTER, STATE MONITORING UNIT, AND SYSTEM COMPRISING SAME
PROCÉDÉ POUR DÉTERMINER DES VALEURS SEUIL D'UNE UNITÉ DE CONTRÔLE D'ÉTAT POUR UNE CENTRALE D'ALARME INCENDIE ET/OU DE COMMANDE D'EXTINCTION ET UNITÉ DE CONTRÔLE D'ÉTAT ET SYSTÈME CORRESPONDANT

(30) Priorität: 25.11.2015 DE 102015223253
(43) Veröffentlichungstag der Anmeldung: 03.10.2018
(73) Patentinhaber: Minimax GmbH, 23843 Bad Oldesloe (DE)
(72) Erfinder: STEFFEN, Hartwig, 23843 Bad Oldesloe (DE)
(74) Vertreter: Eisenführ Speiser
(86) Internationale Anmeldenummer: PCT/EP2016/077776
(87) Internationale Veröffentlichungsnummer: WO 2017/089185

(56) Entgegenhaltungen:
- EP-A1- 0 526 898
- EP-A1- 2 402 832
- DE-A1- 3 127 324
- DE-A1- 3 523 232
- DE-A1-102005 035 409
- US-A1- 2014 015 680

## Beschreibung

Die Erfindung betrifft den Bereich der Brandmelder- und/oder Löschsteuerzentralen, die mit einem auf Grenzwerttechnik basierenden Stromkreis verbunden sind, wobei über den Stromkreis mehrere Teilnehmer mit der Brandmelder- und/oder Löschsteuerzentrale verbunden sind.

Die Teilnehmer dienen, um ein Ereignis, wie z. B. einen Brand oder Änderungen von Schalterstellungen von Löschanlagenkomponenten, zu detektieren. Hierzu weisen die Teilnehmer beispielsweise Sensoren auf, die im einfachsten Falle einen Schalter umfassen, mit denen je nach Einsatzart ein Ereignis detektierbar ist. Wird ein Ereignis detektiert, so wird dies über die grenzwerttechnikbasierenden Stromkreise an die Brandmelder- und/oder Löschsteuerzentrale gemeldet.

Aus dem Stand der Technik sind grenzwerttechnikbasierende Stromkreise allgemein bekannt, und werden auch als Grenzwertmelderlinien oder Stromerhöhungslinien bezeichnet.

DE 35 23 232 C2 offenbart ein Feueralarmsystem zum Ermitteln und Abgeben eines einer Änderung in einer physikalischen Erscheinung der Umgebungsverhältnisse entsprechen den analogen Wertes, mit einer Abtasteinrichtung zum Abtasten eines aus einem Ermittlungsabschnitt abgegebenen analogen Erfassungssignals innerhalb einer bestimmten Zeitspanne, mit einer Datenverarbeitungseinrichtung zur Bildung eines Mittelwertes aus den Abtastdaten, sowie einer Speichereinrichtung, in der diese Abtastdaten speicherbar sind und mit einer Alarmeinrichtung, die das Vorliegen eines Feuers nach Auswertung des Mittelwertes anzeigt, dadurch gekennzeichnet, das die Datenverarbeitungseinrichtung so ausgebildet ist, das die Abtastdaten sequentiell in die Speichereinrichtung eingeschrieben werden, und das aus einer bestimmten Zahl der zuletzt gespeicherten Abtastdaten fortlaufend ein gleitender Mittelwert gebildet wird, wobei jeweils der in der Sequenz älteste Abtastdaten-Speicherwert durch den neuesten ersetzt wird.

DE 31 27 324 A1 beschreibt ein Verfahren, womit in einer Zentrale der Gefahren-, insbesondere Brandmeldeanlage die Meßwerte einer Vielzahl automatischer Melder ausgewertet werden. Dabei wird aus den einzelnen Meßwerten für jeden Melder ein Ruhewert in einer dafür vorgesehenen Einrichtung gebildet und in einen Ruhewertspeicher gespeichert. Bei jedem Abfragezyklus wird aus dem jeweiligen Meldermeßwert, dem gespeicherten Ruhewert und dem in einem Vergleichswertspeicher gespeicherten Vergleichswert ein aktueller Vergleichswert in einer dafür vorgesehenen Einrichtung gebildet und in den Vergleichswertspeicher neu eingeschrieben. Der aktuelle Vergleichswert wird mit einem Grenzwert verglichen. Ist dieser größer oder gleich groß, so wird eine Anzeigeeinrichtung angesteuert. Ist er kleiner, so wird aus dem aktuellen Meldermeßwert und dem gespeicherten Ruhewert ein neuer Ruhewert gebildet und in den Ruhewertspeicher eingeschrieben.

DE 10 2005 035 409 A1 beschreibt eine Messanordnung mit Sensoren, bei der Informationen von den Sensoren über eine Stromänderung an eine Auswerteeinheit übermittelt werden. Ein Schwellwert für eine Detektion einer Stromänderung wird dabei in Abhängigkeit von einem über die Zeit gemittelten Strom festgelegt.

US 2014/015680 A1 offenbart einen Rauchmelder, der eine Rauchdetektionskammer umfasst, die Folgendes umfasst: eine Lichtquelle, die betreibbar ist, um einem Innenraum der Rauchdetektionskammer Strahlung zuzuführen, und einen Lichtdetektor, der betreibbar ist, um Strahlung zu empfangen, die von einem oder mehreren strahlungsstreuenden Partikeln im Inneren gestreut wird die Rauchmeldekammer; ein Alarmsteuermodul, das mit der Rauchdetektionskammer und einem Prozessor in Verbindung steht und betreibbar ist, um einen Alarm zu erzeugen, der das Vorhandensein eines vorbestimmten Schwellenwerts des einen oder der mehreren strahlungsstreuenden Partikel anzeigt; ein computerlesbares Medium, das Anweisungen umfasst, die bei Ausführung durch den Prozessor den Detektor veranlassen, ein Alarmkompensationsschwellenwertverfahren durchzuführen, umfassend: Vergleichen einer kalibrierten Spannungsmessung in klarer Luft mit einer durchschnittlichen Spannungsmessung in klarer Luft; Anpassen einer Alarmschwellenempfindlichkeit, zumindest teilweise basierend auf dem Vergleich der kalibrierten Spannungsmessung in klarer Luft und der durchschnittlichen Spannungsmessung in klarer Luft.

EP 0 526 898 A1 offenbart ein System und Verfahren zum Festlegen einer Alarmschwelle für jedes Mitglied einer Vielzahl von Detektoren oder Sensoren umfasst das Speichern eines Werts, der von jedem Detektor zurückgegeben wird, der einen Zustand klarer Luft anzeigt. Ein zweiter Wert, der von jedem Detektor zurückgegeben wird, der eine Testbedingung anzeigt, wird gespeichert. Die gespeicherten Werte werden mit einem gemeinsamen Detektorkennwert kombiniert, um eine eindeutige Alarmschwelle für jeden Detektor zu erzeugen. Die ermittelten Alarmschwellen können zur späteren Verwendung gespeichert werden. Anschließend kann ein Wert, der von einem Detektor zurückgegeben wird, der einen aktuellen Umgebungszustand anzeigt, mit der zuvor bestimmten Alarmschwelle dieses Detektors verglichen werden. Wenn der aktuell vom Detektor zurückgegebene Wert die vorbestimmte Alarmschwelle überschreitet, kann ein Alarmzustand angezeigt werden.

EP 2 402 832 A1 beschreibt ein Verfahren, welches das Bestimmen eines Kalibrierparameters, der aus verfügbaren Daten ausgewählt, verarbeitet und/oder geschätzt wird, verfasst. Der Parameter basiert auf einem geschätzten Durchschnittswert und/oder einer Varianz verwendeter Daten. Eigenschaften jeder angezeigten Prozess- und/oder Zustandsgröße für jede Betriebsart eines Prozesses und einer Anlage werden statistisch ausgewertet. Referenzanzeigen werden bereitgestellt, um Zeitintervalle zu bestimmen, während von denen angenommen wird, dass sich das Verfahren in einem voreingestellten Betriebsmodus befindet. Ein unerwünschtes Entweichen der Daten wird durch ein Filtermodul während der Verarbeitung der Daten eliminiert. Es wird auch ein unabhängiger Anspruch für ein Anzeigesystem zum Kalibrieren standardisierter Anzeigen von Prozess- und/oder Systemdaten umfasst.

WO 99/67758 beschreibt ein Verfahren zur Erkennung eines Alarmzustands von über Messwerterfassungsmitteln empfangenen Messsignalwerten, wobei ein Alarmzustand ausgelöst wird, wenn für einen aktuell empfangenen Messsignalwert wenigstens ein vorgegebener Grenzwert überschritten wird, ergibt sich eine schnellere Erkennung einer Alarmsituation mit einer gleichzeitig geringeren Fehlalarmrate dadurch, dass in einem ersten Schritt für zeitlich aufeinanderfolgende Messsignalwerte in einem einstellbaren Zeitfenster, deren Lageparameter und ein entsprechender Streuparameter dieser Messsignalwerte von dem Lageparameter berechnet wird, dass in einem zweiten Schritt jeder weitere nachfolgende Messsignalwert zur Gewinnung einer jeweiligen Bewertungsgröße mit dem Lageparameter verglichen und mit dem Streuparameter gewichtet wird, und dass in einem dritten Schritt bei einer einen einstellbaren Ausreißerpararneter überschreitenden Bewertungsgröße ein Ausreißerzustand detektiert wird, während bei einer einen einstellbaren Alarmparameter überschreitenden Bewertungsgröße ein das Vorliegen eines signifikanten Drifts oder Sprungs der Messsignalwerte indizierender Alarmzustand detektiert wird.

Bei den bekannten auf Grenzwerttechnik basierenden Stromkreisen wird zur Meldung von Ereignissen beispielsweise von der Brandmelder- und/oder Löschsteuerzentrale eine vorgegebene konstante Spannung, von z. B. 9 V, für den Stromkreis zur Verfügung gestellt. Der Stromkreis umfasst beispielsweise eine Zweidrahtleitung, wobei die beiden Leitungen über einen Abschlusswiderstand miteinander verbunden. Aufgrund des Abschlusswiderstands fließt ein vordefinierter im Wesentlichen konstanter Strom durch den Stromkreis.

Ferner sind mehrere Teilnehmer, z. B. parallel zum Abschlusswiderstand, verbunden, wobei jeder Teilnehmer eine Stromsenke, z. B. einen schaltbaren Innenwiderstand, aufweist, und im Ereignisfall diesen Innenwiderstand derartig in den Stromkreis einschaltet, dass sich der Gesamtstrom, der von der Brandmelder- und/oder Löschsteuerzentrale am Eingang des Stromkreises gemessen wird, erhöht.

Durch Erfassen dieser Stromerhöhungen in der Brandmelder- und/oder Löschsteuerzentrale lässt sich nun auf ein Ereignis schließen, sodass auf dieses von der Brandmelder- und/oder Löschsteuerzentrale in geeigneter Weise reagiert werden kann.

Außerdem sind andere als die bereits genannten Teilnehmer bekannt, die komplexe Mikroprozessorsysteme aufweisen, und zur Versorgung dieser Mikroprozessorsysteme selbst elektrische Energie für ihren Betrieb benötigen. Die Mikroprozessoren benötigen beispielsweise für kurze Zeit Energie, um dann wieder in einen Sleep-Modus zu gehen. Aufgrund derartiger Teilnehmer kommt es zu Stromschwankungen im Stromkreis. Neben diesen zuletzt genannten Teilnehmern sind auch weitere Teilnehmer bekannt, die statt eines festen Widerstands eine Konstantstromquelle oder Konstantstromsenke aufweisen, um hiermit einen Alarm zu signalisieren. Alle genannten Teilnehmer können auch gemischt in einem Stromkreis, also auf einer Stromerhöhungslinie verwendet werden.

Demnach müssen Schwellenwerte für jede Brandmelder- und/oder Löschsteuerzentrale je nach Aufbau individuell eingestellt werden, die es der Brandmelder- und/oder Löschsteuerzentrale ermöglichen, zwischen einem detektierten Ereignis und einem normalen Ruhebetrieb zu unterscheiden.

Eine optimale Unterscheidung der möglichen Zustände hängt demnach also von einer Vielzahl von Faktoren ab. Zwar wird versucht, verschiedene Störeinflüsse durch Elektronikbauschaltungen, wie z. B. Tiefpassfilter, zu minimieren, wobei trotzdem schwankende Ströme im Bereich von einigen Milliampere bei gleichbleibendem Zustand zu erwarten sind.

Daher müssen die Schwellenwerte nach der Installation der Brandmelder- und/oder Löschsteuerzentrale sowie des Stromkreises und der Teilnehmer aufwändig eingestellt werden. Sie ergeben sich demnach individuell je nach Melderbestückung, Leitungslänge und Beschaffenheit sowie auch vorliegenden Temperaturschwankungen.

Eine rechnerische Dimensionierung der Schwellenwerte ist keine sichere Lösung zur zuverlässigen Unterscheidung der Ereignisse. Häufig sind nämlich weder die genauen Leitungslängen bekannt, noch der Temperaturbereich, dem bestimmte Teile der Leitungen ausgesetzt sind. Außerdem haben die Alarmwiderstände und Stromsenken gewisse Toleranzen und selbst Temperaturabhängigkeiten. Zwar gibt es gewisse Erfahrungswerte zur Einstellung der Schwellenwerte, jedoch sind diese nicht auf jede Konstellation übertragbar.

Es ist somit Aufgabe der vorliegenden Erfindung, eine vereinfachte Möglichkeit zur Einstellung von Schwellenwerten für auf Grenzwerttechnik basierende Stromkreise zu finden, die eine zuverlässige Unterscheidung zwischen verschiedenen Zuständen (Ruhe, Ereignis) der Brandmelder- und/oder Löschsteuerzentrale ermöglicht.

Erfindungsgemäß wird daher eine Zustandsüberwachungseinheit für eine Brandmelder- und/oder Löschsteuerzentrale gemäß Anspruch 1 vorgeschlagen, die mindestens einen Stromkreisanschluss zum Verbinden der Zustandsüberwachungseinheit mit mindestens einem Stromkreis umfasst. Der Stromkreis weist mindestens einen Teilnehmer auf, um Ereignisse zu detektieren.

Ferner umfasst die Zustandsüberwachungseinheit eine Messeinrichtung zum Messen von Werten von Strömen und/oder Spannungen am Stromkreisanschluss. Außerdem ist eine Auswerteeinheit in der Zustandsüberwachungseinheit vorgesehen, in der ein oder mehrere Schwellenwerte speicherbar sind.

Ferner ist die Auswerteeinheit eingerichtet, zumindest in einem Betriebsmodus ein Ereignis beim Über- oder Unterschreiten mindestens des mindestens einen der Schwellenwerte durch mit der Messeinrichtung gemessene Werte von Strömen und/oder Spannungen zu detektieren.

Ferner umfasst die Zustandsüberwachungseinheit einen Speicher oder eine Schnittstelle zum Übertragen von Daten an einen externen Speicher.

Die Zustandsüberwachungseinheit ist eingerichtet, zumindest in einem Lernmodus mit der Messeinrichtung gemessene Werte der Ströme und/oder Spannungen im Speicher zu speichern oder über die Schnittstelle zum externen Speichern auszugeben und den oder die Schwellenwerte in Abhängigkeit der gespeicherten Werte der Ströme und/oder Spannungen zu bestimmen oder abzuändern.

Demnach ist also ein Lernmodus vorgesehen, in dem über einen Zeitraum, in dem sich die Zustandsüberwachungseinheit in diesem Lernmodus befindet, kontinuierlich Werte der Ströme und/oder Spannungen aufgenommen werden. Ein kontinuierliches Aufnehmen ist bevorzugt als ein intervallweises Aufnehmen, z. B. mit einer vorgegebenen Frequenz oder Abtastrate, mehrerer Werte über einen bestimmten Zeitraum zu verstehen.

Demnach wird geprüft, welche Werte die Ströme und/oder Spannungen annehmen, sodass in Abhängigkeit dieser Ströme und/oder Spannungen ein oder mehrere Schwellenwerte bestimmt werden oder falls diese schon bestimmt wurden, diese abgeändert werden.

Gemäß der Erfindung ist die Zustandsüberwachungseinheit zum Bestimmen oder Abändern des oder der Schwellenwerte in Abhängigkeit der hinterlegten Werte der Ströme und/oder Spannungen eingerichtet, eine Häufigkeitsverteilung der gemessenen Werte der Ströme und/oder Spannungen zu bestimmen. Außerdem ist die Zustandsüberwachungseinheit eingerichtet, für den oder die Schwellenwerte die Werte der Ströme und/oder Spannungen auszuwählen, die jeweils einem Minimum in der Häufigkeitsverteilung und/oder die jeweils einem Mittelwert zwischen benachbarten Maxima in der Häufigkeitsverteilung entsprechen.

Demnach werden also im Lernmodus die Werte der Ströme und/oder Spannungen aufgenommen und eine Häufigkeitsverteilung für diese Ströme und/oder Spannungen bestimmt. Um nun die Schwellenwerte zu bestimmen, werden Werte der Ströme und/oder Spannungen ausgewählt, die in einem Minimum der Häufigkeitsverteilung liegen oder die einem Mittelwert zwischen benachbarten Maxima der Häufigkeitsverteilung entsprechen.

Somit sind auf einfache Art und Weise Werte der Ströme und/oder Spannungen bestimmbar, die üblicherweise geeignet sind, um als Schwellenwert zu dienen und zwischen Strömen und/oder Spannungen, die häufig auftreten, zu unterscheiden. Werte der Ströme und/oder Spannungen, die häufig auftreten, können beispielsweise dadurch erzeugt werden, dass im Lernmodus einer, mehrere oder alle Teilnehmer nacheinander oder in unterschiedlichen Reihenfolgen manuell ausgelöst werden. Dies kann z. B. während eines üblichen Revisionsvorgangs, bei dem die Funktion der Brandmelder- und/oder Löschsteuerzentrale in regelmäßigen Abständen geprüft wird, erfolgen.

Gemäß einer weiteren Ausführungsform umfasst der Lernmodus einen ersten untergeordneten Modus, der eingerichtet ist, einen Ruhewert durch Bestimmen eines Maximums der Häufigkeitsverteilung aller im ersten untergeordneten Modus gemessener Werte der Ströme und/oder Spannungen zu detektieren. Zusätzlich oder alternativ umfasst der Lernmodus einen zweiten untergeordneten Modus, der eingerichtet ist, einen ersten Ereigniswert durch Bestimmen eines Maximums der Häufigkeitsverteilung aller im zweiten untergeordneten Modus gemessenen Werte der Ströme und/oder Spannungen zu detektieren.

Gemäß diesem Ausführungsbeispiel umfasst der Lernmodus außerdem zusätzlich oder alternativ einen dritten untergeordneten Modus, der eingerichtet ist, einen zweiten Ereigniswert durch Bestimmen eines Maximums der Häufigkeitsverteilung aller im dritten untergeordneten Modus aufgenommenen Werte der Ströme und/oder Spannungen zu detektieren.

Demnach wird also in einem ersten untergeordneten Modus ein Ruhewert, in einem zweiten untergeordneten Modus ein erster Ereigniswert und/oder in einem dritten untergeordneten Modus ein zweiter Ereigniswert bestimmt.

Zum Bestimmen der Werte wird z. B. im ersten untergeordneten Modus das Zustandsmodul in den Lernmodus gebracht, nachdem die komplette Brandmelder- und/oder Löschsteuerzentrale mit allen vorgesehenen Teilnehmern und dem Stromkreis installiert worden ist. Nun werden beispielsweise verschiedene Bedingungen, wie Temperaturen oder andere Einflüsse auf die Brandmelder- und/oder Löschsteuerzentrale, variiert, die den Ruhewert beeinflussen. Für die Dauer des ersten untergeordneten Modus wird demnach eine Häufigkeitsverteilung bestimmt und das Maximum dieser Häufigkeitsverteilung als Ruhewert festgelegt.

Im zweiten untergeordneten Modus werden dann mehrere Teilnehmer separat nacheinander einzeln ausgelöst. Auch hierbei können zusätzlich Parameter, wie die Umgebungstemperatur oder andere Einflüsse, variiert werden. Auch für den Zeitraum des zweiten untergeordneten Modus wird dann eine Häufigkeitsverteilung bestimmt und das Maximum als erster Ereigniswert festgelegt.

Im dritten untergeordneten Modus werden dann immer mindestens zwei Teilnehmer separat nacheinander ausgelöst, wobei variiert wird, welche zwei Teilnehmer auslösen. Auch für diesen dritten untergeordneten Modus wird eine Häufigkeitsverteilung bestimmt und das Maximum als zweiter Ereigniswert festgelegt.

Die Histogramme oder Häufigkeitsverteilungen werden auf Grundlage der im jeweiligen Modus gemessenen und gespeicherten Werte der Ströme und/oder Spannungen ermittelt.

Somit sind auf einfache Art und Weise verschiedene Strom- und/oder Spannungswerte detektierbar, die entweder für einen Ruhezustand oder einen ersten oder zweiten Ereigniszustand repräsentativ sind. Schwellenwerte können demnach in einfacher Art und Weise aufgrund der bestimmten Werte, nämlich dem Ruhewert, dem ersten Ereigniswert und/oder dem zweiten Ereigniswert bestimmt werden.

Gemäß einer weiteren Ausführungsform ist die Zustandsüberwachungseinheit ferner eingerichtet, einen ersten Schwellenwert zu bestimmen, der einem Mittelwert aus dem Ruhewert und dem ersten Ereigniswert entspricht. Zusätzlich oder alternativ ist die Zustandsüberwachungseinheit gemäß diesem Ausführungsbeispiel eingerichtet, einen zweiten Schwellenwert zu bestimmen, der einem Mittelwert aus dem ersten Ereigniswert und dem zweiten Ereigniswert entspricht.

Demnach sind vorteilhafterweise besonders geeignete Schwellenwerte zu bestimmen, indem nämlich Schwellenwerte gewählt werden, die möglichst weit von den einzelnen Werten, die unterschiedliche Zustände signalisieren, entfernt liegen.

Gemäß einer weiteren Ausführungsform umfasst die Zustandsüberwachungseinheit einen Prüfmodus, um zu prüfen, ob alle im ersten untergeordneten Modus gemessenen Werte der Ströme und/oder Spannungen unterhalb des ersten Schwellenwerts und/oder alle im zweiten untergeordneten Modus gemessenen Werte der Ströme und/oder Spannungen oberhalb des ersten Schwellenwerts liegen.

Alternativ oder zusätzlich dient der Prüfmodus, um zu prüfen, ob alle im zweiten untergeordneten Modus gemessenen Werte der Ströme und/oder Spannungen unterhalb des zweiten Schwellenwerts und/oder alle im dritten untergeordneten Modus gemessenen Werte der Ströme und/oder Spannungen oberhalb des zweiten Schwellenwerts liegen.

Demnach wird also nach Auswählen der Schwellenwerte überprüft, ob diese tatsächlich so festgelegt wurden, dass die den Schwellenwerten entsprechenden Werte nicht auf ein Ereignis oder einen Ruhezustand hinweisen, sondern von Werten, die auf einen Zustand hinweisen, entfernt liegen.

Gemäß einer weiteren Ausführungsform ist die Zustandsüberwachungseinheit ferner eingerichtet, auch im Betriebsmodus intervallweise oder ständig Werte der Ströme und/oder Spannungen im Speicher zu speichern und/oder über die Schnittstelle zum externen Speichern auszugeben. Außerdem ist die Zustandsüberwachungseinheit eingerichtet, den oder die Schwellenwerte während des Betriebsmodus automatisch und/oder durch manuelle Aufforderung im Betriebsmodus oder im Lernmodus basierend auf den im Betriebsmodus intervallweise oder ständig gemessenen Werten zu bestimmen oder abzuändern.

Demnach ist also eine automatische Nachjustierung der Schwellenwerte möglich. Ferner ist es auch möglich, dass z. B. bei einem Wartungsintervall, nachdem die Brandmelder- und/oder Löschsteuerzentrale mit der Zustandsüberwachungseinheit bereits einige Zeit im Betrieb war, von einer Person, die eine Wartung durchführt, der oder die Schwellenwerte durch manuelle Aufforderung nachjustiert werden.

Gemäß einer weiteren Ausführungsform ist die Zustandsüberwachungseinheit eingerichtet, bei einer manuellen Aufforderung durch einen Benutzer zum Bestimmen oder Abändern des oder der Schwellenwerte, den oder die zum Bestimmen oder Abändern ermittelten Schwellenwerte für den Benutzer anzuzeigen oder über eine Schnittstelle zum Anzeigen, z. B. auf einer Anzeige, auszugeben. Zusätzlich oder alternativ ist die Zustandsüberwachungseinheit eingerichtet, über die Schnittstelle oder Eingabemittel Benutzerbefehle entgegenzunehmen. Dies dient, um in Abhängigkeit der Befehle einen oder mehrere hinterlegte Schwellenwerte durch Ersetzen mit dem oder den ermittelten Schwellenwerten abzuändern, einen, alle oder mehrere der Schwellenwerte und/oder der hinterlegten Werte der Ströme und/oder Spannungen zu löschen und/oder zwischen den vorgenannten Modi umzuschalten.

Demnach ist also von einem Benutzer vor dem Bestimmen oder Abändern eines, mehrerer oder aller Schwellenwerte ein Kontrollieren des oder der ermittelten Schwellenwerte, z. B. visuell mit einer Anzeige, möglich. Außerdem kann der Benutzer mit dem Eingabemittel die einzelnen Modi auswählen, um beispielsweise den Lernmodus, den ersten, zweiten und/oder dritten untergeordneten Modus sowie den Prüfmodus auszuwählen.

Gemäß einer Ausführungsform ist die Zustandsüberwachungseinheit derart ausgebildet, um als Modul in eine Brandmelder- und/oder Löschsteuerzentrale eingesetzt zu werden. Alternativ ist die Zustandsüberwachungseinheit als integriertes Modul der Brandmelder- und/oder Löschsteuerzentrale ausgebildet.

Ferner umfasst die Erfindung gemäß Anspruch 7 ein Verfahren zum Bestimmen von Schwellenwerten für eine Zustandsüberwachungseinheit für eine Brandmelder- und/oder Löschsteuerzentrale sowie eine Brandmelder- und/oder Löschsteuerzentrale mit einer Zustandsüberwachungseinheit nach einer der vorgenannten Ausführungsformen, insbesondere zum Ausführen des Verfahrens, wie in den unabhängigen Ansprüchen definiert.

Zudem umfasst die Erfindung ein Brandmeldesystem mit einer Brandmelder- und/oder Löschsteuerzentrale mit einer Zustandsüberwachungseinheit nach einer der beanspruchten Ausführungsformen mit einem Stromkreis und mehreren Teilnehmern, insbesondere zur Ausführung des Verfahrens.

Weitere Ausführungsformen ergeben sich anhand der Zeichnungen näher erläuterten Ausführungsbeispiele. In den Zeichnungen zeigen:
- Fig. 1: ein Ausführungsbeispiel eines Brandmeldesystems,
- Fig. 2: eine vergrößerte Darstellung eines Ausführungsbeispiels einer Zustandsüberwachungseinheit und
- Fig. 3: eine Messung einer Häufigkeitsverteilung sowie die Bestimmung von Werten und Schwellenwerten.

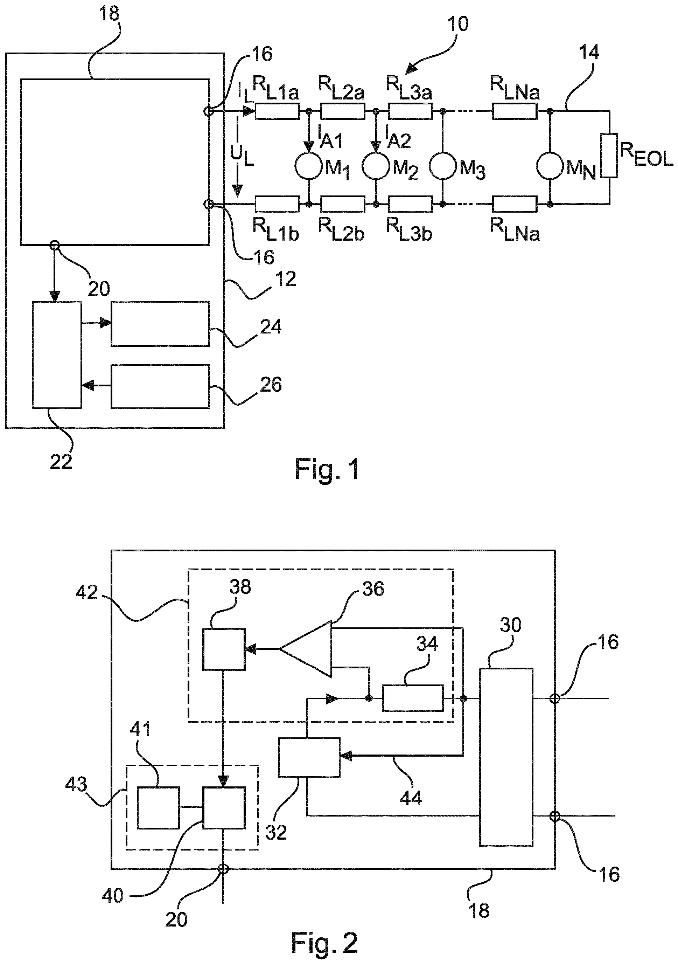

Fig. 1 zeigt ein Brandmeldesystem 10, das eine Brandmelder- und/oder Löschsteuerzentrale 12 umfasst. Ferner umfasst das Brandmeldesystem 10 einen Stromkreis 14, der eine Zweidrahtleitung umfasst, wobei die Leitungen der Zweidrahtleitung an einem Ende über einen Abschlusswiderstand R_{EOL} miteinander verbunden sind. Am anderen Ende sind die Leitungen der Zweidrahtleitungen über einen Stromkreisanschluss 16 mit einer Zustandsüberwachungseinheit 18 verbunden.

Die Zustandsüberwachungseinheit 18 ist beispielsweise eine separate Einheit, z. B. ein Modul, und ist insbesondere als Hutschienenmodul, welches auf einer Hutschiene der Brandmelder- und/oder Löschsteuerzentrale 12 aufgeschnappt werden kann, ausgebildet. Durch eine Bussystemschnittstelle wird das Zustandsüberwachungsmodul 18 über einen internen Bus mittels einer Schnittstelle 20 mit einer übergeordneten Rechnereinheit 22 verbunden. Vorzugsweise ist die Bussystemschnittstelle am Gehäuse des Hutschienenmoduls, das die Zustandsüberwachungseinheit 18 umfasst, angebracht.

In einer vorteilhaften Ausführungsform umfasst die Zustandsüberwachungseinheit 18 mindestens eine elektronische Flachbaugruppe oder eine andere Integration von elektronischen Bauelementen, wie beispielsweise einer On-Chip (System-on-Chip)-Ausführung, die alle notwendigen elektronischen Bauteile und Baugruppen für die Funktionalität der Zustandsüberwachungseinheit 18 umfasst. Die elektronischen Bauelemente werden unter Bezugnahme auf Fig. 2 später im Detail beschrieben.

Ferner ist eine Schnittstelle 20 sowie eine übergeordnete Rechnereinheit 22 vorgesehen. Die übergeordnete Rechnereinheit 22 ist nicht Bestandteil der Zustandsüberwachungseinheit 18, sondern lediglich über die Schnittstelle mit der Zustandsüberwachungseinheit 18 verbunden. Mit der übergeordneten Rechnereinheit 22 ist außerdem eine Anzeigeeinrichtung 24 verbunden. Außerdem sind Eingabemittel 26 vorgesehen, mit denen Benutzerbefehle mittels der übergeordneten Rechnereinheit 22 über die Schnittstelle 20 der Zustandsüberwachungseinheit 18 zugeführt werden können. Ferner dienen die Eingabemittel 26 beispielsweise zur Konfiguration der Brandmelder- und/oder Löschsteuerzentrale 12. Die Anzeigeeinrichtung 24 dient zur Anzeige der Konfiguration, sowie zur Anzeige des Betriebszustands der Brandmelder- und/oder Löschsteuerzentrale 12 oder der verschiedenen Modi, die mit den Eingabemitteln 26 ausgewählt werden.

Ferner ist der Stromkreis 14, der über den Stromkreisanschluss 16 mit der Zustandsüberwachungseinheit 18 verbunden ist, mit den Teilnehmern M₁ bis M_{N} verbunden. Die Teilnehmer sind somit parallel zum Abschlusswiderstand R_{EOL} geschaltet. Die Widerstände R_{L1a} bis R_{LNa} sowie R_{L1b} bis R_{LNb} entsprechen den Leitungswiderständen zwischen den einzelnen Teilnehmern M₁ bis M_{N}. Jeder Teilnehmer M₁ bis M_{N} weist eine nicht dargestellte Energiesenke und ein nicht dargestelltes Element zum Detektieren von Ereignissen auf. Dieses Element ist z. B. ein Sensor, der Brandkenngrößen, wie z. B. Temperatur, Rauchaerosole, elektromagnetische Strahlung von Flammen, Funken oder Glutnester oder Brandgase detektiert, oder ein einfacher Schalter, der Änderungen von Schalterstellungen von Löschanlagenkomponenten erfasst, wie z. B. die Überwachung der Ventilstellung eines Ventils, bei welcher der Schalter durch Öffnen oder Schließen des Ventils geöffnet oder geschlossen wird, um dadurch ein Ereignis zu detektieren.

Demnach dienen die Teilnehmer zu verschiedenen Zwecken innerhalb des Brandmeldesystems, z. B. als:
- Endschalter für die Positionserfassung von z. B. Kugelhähnen, Absperrschiebern, Absperrklappen oder Schiebern allgemein;
- Druckschalter für Luftdruckmessung, z. B. im Druckluftwasserbehälter oder im Trockenrohrnetz;
- Schwimmerschalter für Füllstandsmessungen in Druckluftwasserbehältern, drucklosen Wasserbehältern und anderen Gefäßen zur Löschfluidbevorratung;
- Temperaturschalter, beispielsweise für die Überwachung der Umgebungstemperatur in einer Sprinklerzentrale;
- Pumpendruckschalter zum Starten des Sprinklerpumpenmotors bei Druckabfall im löschfluidführenden Rohrleitungsnetz oder in einer Armatur;
- Brandmelder, wie automatische Brandmelder oder Handfeuermelder, sowie Gefahren zur Erfassung von Ereignismeldungen, Feuermeldungen und Störungen.

Übliche Normen erlauben die Verwendung von bis zu 32 Teilnehmern M₁ bis M_{N} auf einer Stromerhöhungslinie, nämlich dem Stromkreis 14. Sie können an beliebigen Stellen der Stromerhöhungslinie, also dem Stromkreis 14, der hier als Zweidrahtleitung ausgeführt ist, platziert werden. Die Teilnehmer M₁ bis M_{N} können im einfachsten Fall aus einem Schalter und einem in Reihe geschalteten Widerstand, von z. B. 470 Ω, ausgeführt sein. Wird ein Schalter im Alarmfall geschlossen, so kommt es zu einer Stromerhöhung, um beispielsweise 18 mA, die von der Zustandsüberwachungseinheit 18 erkannt werden kann.

Es werden in Normen Verfahren zur Vermeidung von Fehlalarmen vorgeschlagen. Ein Verfahren erwartet mindestens zwei gleichzeitig ausgelöste Teilnehmer M₁ bis M_{N}. In diesem Fall stellt sich rechnerisch ein Strom ein, der höher ist, als bei der Auslösung nur eines Teilnehmers. Beispielsweise wäre hier ein Strom von 41 mA möglich.

Bei den zuletzt genannten Stromwerten sind die Widerstände R_{L1a} bis R_{LNa} und R_{L1b} bis R_{LNb} unberücksichtigt. Werden diese berücksichtigt, so hängen die von der Zustandsüberwachungseinheit 18 gemessenen Ströme auch davon ab, ob sich die beiden Teilnehmer M₁ bis M_{N}, die ein Ereignis detektieren, am Anfang des Stromkreises 14, also nahe der Zustandsüberwachungseinheit 18, oder am Ende, also in der Nähe des Abschlusswiderstandes R_{EOL} befinden.

Neben den Alarm- oder Ereignisfällen, bei denen ein oder mehrere Teilnehmer M₁ bis M_{N} in Alarm versetzt sind, also ein Ereignis detektiert haben, muss die Zustandsüberwachungseinheit 18 auch Störungen des Stromkreises 14 erkennen. Sinkt der Strom weit unter den Ruhestrom, der z. B. 5 mA beträgt, ist dies ein Hinweis, dass der Stromkreis 14 unterbrochen ist. Steigt der Strom auf höhere Werte an, kann die Zustandsüberwachungseinheit 18 von einem Kurzschluss des Stromkreises 14 ausgehen.

Demnach dient die Zustandsüberwachungseinheit 18 zum Erkennen von Ereignissen, indem diese eine im Wesentlichen konstante Linienspannung U_{L} am Stromkreis 14 zur Verfügung stellt. Ein üblicher Spannungswert liegt bei etwa 9 V. Es sind jedoch aus Ausführungen bis 24 V üblich. Der Abschlusswiderstand R_{EOL} weist z. B. einen Wert von 1,8 kΩ auf.

Die Leitungen des Stromkreises 14 sind beispielsweise Leitungen mit einem Querschnitt von 0,8 mm² und weisen daher einen Widerstand von etwa 4 Ω pro 100 m Leitungslänge bei 20° auf. Bereits dieser Widerstand ist nicht konstant, sondern kann mit der Temperatur schwanken. Im vorgenannten Leitungsquerschnitt variiert der Widerstand bereits um mehr als 50 mΩ bei einer Schleifenlänge von 100 m und einer Temperaturdifferenz von 10°. Leitungswege sind in der Praxis häufig bis zu 1.000 m lang. Der Strom I_{L} durch den Stromkreis 14 wird daher von der Zustandsüberwachungseinheit gemessen und variiert z. B. wie soeben ausgeführt mit der Temperatur.

Fig. 2 zeigt eine Zustandsüberwachungseinheit 18 im detaillierten Aufbau. Die Zustandsüberwachungseinheit 18 weist einen Stromkreisanschluss 16 auf, der mit einer Signalaufbereitung 30 verbunden ist. Die Signalaufbereitung 30 enthält z. B. Filter zum Glätten der Spannungen und Ströme im Stromkreis 14.

Ferner ist eine Spannungsquelle 32 vorgesehen, über die eine Spannung am Stromkreisanschluss 16, z. B. von 9 V, anlegbar ist. Ferner ist zwischen der Spannungsquelle 32 und dem Stromkreisanschluss 16 ein Shunt-Widerstand 34 vorgesehen. Dieser dient zur Strommessung. Fließt nämlich ein Strom durch den Stromkreis 14, der am Stromkreisanschluss 16 angeschlossen ist, so erfolgt ein Spannungsabfall über dem Shunt-Widerstand 34. Dieser Spannungsabfall wird mithilfe einer Strommessstufe 36 ermittelt und über einen Analog-Digital-Wandler 38 einer Rechnereinheit 40 zugeführt. Shunt-Widerstand 34, Strommessstufe 36 und AD-Wandler 38 bilden eine Messeinrichtung 42.

Da über den Shunt-Widerstand 34 eine Spannung abfällt, ist eine Feedbackleitung 44 vorgesehen, um die Spannungsquelle 32 nachzuregeln, sodass am Stromkreisanschluss 16 eine im Wesentlichen konstante Spannung anliegt. Die Rechnereinheit 40 ist mit einem Speicher 41 verbunden. Rechnereinheit 40 und Speicher 41 entsprechen hier einer Auswerteeinheit 43. In einem Lernmodus dient die Auswerteeinheit 43 zum Speichern der mit der Messeinrichtung 42 gemessenen Ströme I_{L}. Insbesondere werden die Werte der Ströme I_{L} durch den Stromkreis 14, die mittels der Messeinrichtung 42 im Lernmodus gemessen werden, im Speicher 41 der Auswerteeinheit 43 gespeichert.

Mittels der Messeinrichtung 42 lassen sich demnach verschiedene Stromwerte messen, die auftreten, wenn ein Ereignis von einem Teilnehmer M₁ bis M_{N} detektiert wird oder wenn kein Ereignis detektiert wird.

In Abhängigkeit der gespeicherten Werte werden Schwellenwerte ermittelt. Diese Schwellenwerte dienen später zum Unterscheiden zwischen verschiedenen Strömen auf dem Stromkreis, nämlich einem Ruhestrom, bei dem kein Teilnehmer M₁ bis M_{N} ein Ereignis detektiert hat, einem ersten Ereigniswert, bei dem ein einzelner Teilnehmer ein Ereignis detektiert hat, und einem zweiten Ereigniswert, bei dem mindestens zwei Teilnehmer M₁ bis M_{N} ein Ereignis detektiert haben.

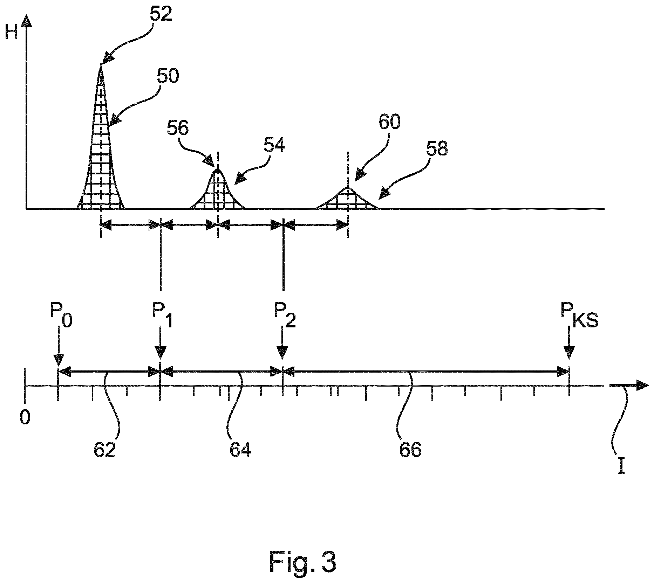

Im Folgenden wird im Detail erklärt, wie mit der Auswerteeinheit 43 die Schwellenwerte bestimmt werden. Hierzu wird Bezug auf Fig. 3 genommen.

Zunächst wird ein erster Schwellenwert P₁ bestimmt.

Hierzu wird die Häufigkeitsverteilung 50 eines Ruhewerts I_{R} bestimmt, indem in einem Lernmodus mit der Auswerteeinheit 43 der Zustandsüberwachungseinheit 18 Werte des Stroms I_{L} in einem ersten untergeordneten Modus aufgenommen werden. Hierbei ist entweder eine vordefinierte Zeitdauer oder eine beliebige Zeitdauer der Aufzeichnung, also des Abspeicherns der gemessenen Werte, z. B. von der Installation bis zur Inbetriebnahme der Brandmelder- und/oder Löschsteuerzentrale 12 gewählt. Aus dieser Häufigkeitsverteilung 50 wird ein Maximum 52 bestimmt, das dann als Ruhewert I_{R} definiert wird.

Im darauffolgenden Schritt werden in einem zweiten untergeordneten Modus alle an den Stromkreis 14 angeschlossenen Teilnehmer M₁ bis M_{N} einzeln in Alarm versetzt, also so, dass diese ein Ereignis detektieren. Hierbei werden wiederum die Stromwerte I_{L} gemessen und im Speicher 41 gespeichert. Aus diesen Werten wird dann die Häufigkeitsverteilung 54 bestimmt. Aus der Häufigkeitsverteilung 54 wird ebenfalls das Maximum 56 bestimmt und als erster Ereigniswert I_{E1} definiert. Daraufhin wird der Mittelwert aus dem Ruhewert I_{R} sowie der ersten Ereigniswert I_{E1} bestimmt. Dieser Mittelwert wird als erster Schwellenwert P₁ definiert.

In einem Prüfmodus wird dann noch geprüft, ob alle Messwerte bei der Messung im ersten untergeordneten Modus unterhalb von P₁ liegen und alle Messwerte bei der Messung im zweiten untergeordneten Modus oberhalb von P₁ liegen. Sollte dies nicht der Fall sein, so wird eine Fehlermeldung von der Auswerteeinheit 43 ausgegeben.

Ferner wird ein zweiter Schwellenwert P₂ ermittelt, indem in einem dritten untergeordneten Modus nacheinander gleichzeitig zwei Teilnehmer M₁ bis M_{N} ausgelöst werden. Es werden mindestens die beiden Teilnehmer M₁ bis M_{N} ausgelöst, die der Brandmelder- und/oder Löschsteuerzentrale 12 am nächsten auf dem Stromkreis 14 liegen, sowie die beiden Teilnehmer M₁ bis M_{N}, die dem Abschlusswiderstand R_{EOL} am nächsten am Stromkreis 14 liegen. Weitere Kombinationen sind ebenfalls vorteilhaft. Aus diesen Werten wird dann eine weitere Häufigkeitsverteilung 58 durch die hinterlegten Werte im dritten untergeordneten Modus erzeugt und auch aus dieser Verteilung 58 ein Maximum 60 bestimmt. Dieses Maximum 60 wird dann als zweiter Ereigniswert I_{E2} definiert.

Im nächsten Schritt wird nun der Schwellenwert P₂ als Mittelwert zwischen dem ersten Ereigniswert I_{E1}, der im zweiten untergeordneten Modus, und dem zweiten Ereigniswert I_{E2}, der im dritten untergeordneten Modus bestimmt wurde, ermittelt. Es wird erneut von der Rechnereinheit 40 überprüft, ob alle Messwerte des zweiten untergeordneten Modus unterhalb des zweiten Schwellenwerts P₂ und alle Messwerte des dritten untergeordneten Modus oberhalb des zweiten Schwellenwerts P₂ liegen. Im Fehlerfall wird dies signalisiert.

Somit sind eindeutig die Bereiche 62 bis 66 definiert. Diese Bereiche entsprechen Bereichen von Stromwerten, die verschiedenen Ereignissen zuzuordnen sind. Die Bereiche 62 bis 66 sind durch die Schwellenwerte P₁ und P₂ voneinander getrennt. Im Bereich 62 beispielsweise wird davon ausgegangen, dass kein Ereignis auftritt und somit ein Ruhezustand vorliegt. Im Bereich 64 wird dann von einem detektierten Ereignis ausgegangen, das mit einem Teilnehmer M₁ bis M_{N} detektiert wurde. Der daran grenzende Bereich 66 entspricht dann einem Bereich eines Stromwerts, bei dem mindestens zwei Teilnehmer M₁ bis M_{N} ausgelöst haben.

Ferner sind noch die Schwellenwerte P₀ und P_{KS} eingetragen. Wird von der Messeinrichtung 42 ein Strom detektiert, der unter dem Wert P₀ liegt, liegt ein Drahtbruch vor. Wird ein Wert gemessen, der oberhalb dem Schwellenwert P_{KS} liegt, wird von einem Kurzschluss ausgegangen. Die Werte P₀ und P_{KS} sind beispielsweise fest im Speicher 41 voreingestellt.

Somit sind die Schwellenwerte P₁ und P₂ zur Unterscheidung eines Ruhezustands oder eines Ereigniszustands auf einfache Art und Weise und besonders präzise und zuverlässig bestimmbar und im Speicher 41 nach dem Bestimmen hinterlegbar.

### Bezugszeichenliste

| | | | |
|---|---|---|---|
| 10 | Brandmeldesystem | | |
| 12 | Brandmelder- und/oder Löschsteuerzentrale | | |
| 14 | Stromkreis | | |
| R_{EOL} | Abschlusswiderstand | | |
| 16 | Stromkreisanschluss | | |
| 18 | Zustandsüberwachungseinheit | I_{E1} | erster Ereigniswert |
| 20 | Schnittstelle | I_{E2} | zweiter Ereigniswert |
| 22 | Übergeordnete Rechnereinheit | 50, 54, 58 | Häufigkeitsverteilung |
| 24 | Anzeigeeinrichtung | 52, 56, 60 | Maximum |
| 26 | Eingabemittel | I_{R} | Ruhewert |
| M₁ bis M_{N} | Teilnehmer | 62 bis 66 | Bereiche |
| R_{L1a} bis R_{LNa} | Widerstände | P₀, P_{KS} | Schwellenwerte |
| R_{L1b} bis R_{LNb} | | | |
| I_{L} | Strom | | |
| 30 | Signalaufbereitung | | |
| 32 | Spannungsquelle | | |
| 34 | Shunt-Widerstand | | |
| 36 | Strommessstufe | | |
| 38 | Analog-Digital-Wandler | | |
| 40 | Rechnereinheit | | |
| 41 | Speicher | | |
| 42 | Messeinrichtung | | |
| 43 | Auswerteeinheit | | |
| 44 | Feedbackleitung | | |
| P₁ | Erster Schwellenwert | | |
| P₂ | Zweiter Schwellenwert | | |

## Patentansprüche

1. Zustandsüberwachungseinheit für eine Brandmelder- und/oder Löschsteuerzentrale (12) umfassend:
- mindestens einen Stromkreisanschluss (16) zum Verbinden der Zustandsüberwachungseinheit (18) mit mindestens einem Stromkreis (14), wobei der Stromkreis (14) mindestens einen Ereignisse detektierenden Teilnehmer (M₁ bis M_{N}) aufweist,
- eine Messeinrichtung (42) zum Messen von Werten von Strömen (I_{L}) und/oder Spannungen am Stromkreisanschluss (16),
- eine Auswerteeinheit (43), in der ein oder mehrere Schwellenwerte (P₁, P₂) speicherbar sind, wobei
- die Auswerteeinheit (43) eingerichtet ist, zumindest in einem Betriebsmodus ein Ereignis beim Über- oder Unterschreiten des mindestens einen Schwellenwerts (P₁, P₂) durch mit der Messeinrichtung (42) gemessene Werte von Strömen (I_{L}) und/oder Spannungen zu detektieren,
- einen Speicher (41) oder eine Schnittstelle (20) zum Übertragen von Daten an einen externen Speicher, wobei
- die Zustandsüberwachungseinheit (18) eingerichtet ist, zumindest in einem Lernmodus mit der Messeinrichtung (42) gemessene Werte der Ströme (I_{L}) und/oder Spannungen im Speicher (41) zu speichern oder über die Schnittstelle (20) zum externen Speichern auszugeben und den oder die Schwellenwerte (P₁, P₂) in Abhängigkeit der gespeicherten Werte der Ströme (I_{L}) und/oder Spannungen zu bestimmen oder abzuändern, wobei
die Zustandsüberwachungseinheit (18) zum Bestimmen oder Abändern des oder der Schwellenwerte (P₁, P₂) in Abhängigkeit der hinterlegten Werte der Ströme (I_{L}) und/oder Spannungen eingerichtet ist, eine Häufigkeitsverteilung der gemessenen Werte der Ströme (I_{L}) und/oder Spannungen zu bestimmen und für den oder die Schwellenwerte (P₁, P₂) die Werte der Ströme (I_{L}) und/oder Spannungen auszuwählen, die jeweils einem Minimum in der Häufigkeitsverteilung und/oder die jeweils einem Mittelwert zwischen benachbarten Maxima in der Häufigkeitsverteilung entsprechen.

2. Zustandsüberwachungseinheit nach Anspruch 1, wobei der Lernmodus ferner umfasst:
- einen ersten untergeordneten Modus, der eingerichtet ist, um einen Ruhewert (I_{R}) durch Bestimmen eines Maximums (52) der Häufigkeitsverteilung (50) aller im ersten untergeordneten Modus gemessenen Werte der Ströme (I_{L}) und/oder Spannungen zu detektieren und/oder
- einen zweiten untergeordneten Modus, der eingerichtet ist, um einen ersten Ereigniswert (I_{E1}) durch Bestimmen eines Maximums (56) der Häufigkeitsverteilung (54) aller im zweiten untergeordneten Modus gemessenen Werte der Ströme (I_{L}) und/oder Spannungen zu detektieren und/oder
- einen dritten untergeordneten Modus, der eingerichtet ist, um einen zweiten Ereigniswert (I_{E2}) durch Bestimmen eines Maximums (60) der Häufigkeitsverteilung (58) aller im dritten untergeordneten Modus aufgenommen Werte der Ströme (I_{L}) und/oder Spannungen zu detektieren.

3. Zustandsüberwachungseinheit nach Anspruch 2, wobei die Zustandsüberwachungseinheit (18) eingerichtet ist,
- einen ersten Schwellenwert (P₁) zu bestimmen, der einem Mittelwert aus dem Ruhewert (I_{R}) und dem ersten Ereigniswert (I_{E1}) entspricht und/oder
- einen zweiten Schwellenwert (P₂) zu bestimmen, der einem Mittelwert aus dem ersten Ereigniswert (I_{E1}) und dem zweiten Ereigniswert (I_{E2}) entspricht.

4. Zustandsüberwachungseinheit nach Anspruch 3, wobei die Zustandsüberwachungseinheit (18) einen Prüfmodus umfasst, um zu prüfen, ob
- alle im ersten untergeordneten Modus gemessenen Werte der Ströme (I_{L}) und/oder Spannungen unterhalb des ersten Schwellenwerts (P₁) und/oder alle im zweiten untergeordneten Modus gemessenen Werte der Ströme (I_{L}) und/oder Spannungen oberhalb des ersten Schwellenwerts (P₁) liegen und/oder
- alle im zweiten untergeordneten Modus gemessenen Werte der Ströme (I_{L}) und/oder Spannungen unterhalb des zweiten Schwellenwerts (P₂) und/oder alle im dritten untergeordneten Modus gemessenen Werte der Ströme (I_{L}) und/oder Spannungen oberhalb des zweiten Schwellenwerts (P₂) liegen.

5. Zustandsüberwachungseinheit nach einem der vorhergehenden Ansprüche, wobei
die Zustandsüberwachungseinheit (18) eingerichtet ist, im Betriebsmodus intervallweise oder ständig gemessene Werte der Ströme (I_{L}) und/oder Spannungen im Speicher (41) zu speichern und/oder über die Schnittstelle (20) zum externen Speichern auszugeben und den oder die Schwellenwerte (P₁, P₂) während des Betriebsmodus automatisch und/oder durch manuelle Aufforderung im Betriebsmodus oder im Lernmodus die intervallweise oder ständig gemessenen Werte durch einen Benutzer zu bestimmen oder abzuändern.

6. Zustandsüberwachungseinheit nach einem der vorhergehenden Ansprüche, wobei
die Zustandsüberwachungseinheit (18) eingerichtet, bei einer manuellen Aufforderung durch einen Benutzer zum Bestimmen oder Abändern des oder der Schwellenwerte (P₁, P₂), den oder die zum Bestimmen oder Abändern ermittelten Schwellenwerte (P₁, P₂) für den Benutzer anzuzeigen oder über eine Schnittstelle (20) zum Anzeigen, z. B. auf einer Anzeigeeinrichtung (24), auszugeben und/oder
über die Schnittstelle (20) oder Eingabemittel (26) Benutzerbefehle entgegenzunehmen, um in Abhängigkeit der Befehle einen oder mehrere hinterlegte Schwellenwerte (P₁, P₂) durch Ersetzen mit dem oder den ermittelten Schwellenwerten (P₁, P₂) abzuändern, einen, alle oder mehrere der Schwellenwerte (P₁, P₂) und/oder der hinterlegten Werte der Ströme (I_{L}) und/oder Spannungen zu löschen und/oder zwischen den Modi umzuschalten.

7. Verfahren zum Bestimmen von mindestens einem Schwellenwert (P₁, P₂) für eine Zustandsüberwachungseinheit (18) für eine Brandmelder- und/oder Löschsteuerzentrale (12), wobei mit einer Messeinrichtung (42) Werte von Strömen (I_{L}) und/oder Spannungen an mindestens einem Stromkreisanschluss (16) der Zustandsüberwachungseinheit (18) gemessen werden, wobei
mit einer Auswerteeinheit (43) zumindest in einem Betriebsmodus ein Ereignis beim Über- oder Unterschreiten mindestens eines Schwellenwerts (P₁, P₂) durch mit der Messeinrichtung (42) gemessene Werte von Strömen (I_{L}) und/oder Spannungen detektiert wird, wobei
zumindest in einem Lernmodus die gemessenen Werte der Ströme (I_{L}) und/oder Spannungen in einem Speicher (41) gespeichert oder über eine Schnittstelle (20) zum externen Speichern ausgegeben werden, und
mindestens ein Schwellenwert (P₁, P₂) in Abhängigkeit der hinterlegten Werte der Ströme (I_{L}) und/oder Spannungen bestimmt oder abgeändert werden, wobei zum Bestimmen oder Abändern des oder der Schwellenwerte (P₁, P₂) in Abhängigkeit der hinterlegten Werte der Ströme (I_{L}) und/oder Spannungen eine Häufigkeitsverteilung der gemessenen Werte der Ströme (I_{L}) und/oder Spannungen bestimmt wird und für den oder die Schwellenwerte (P₁, P₂) die Werte der Ströme (I_{L}) und/oder Spannungen ausgewählt werden, die jeweils einem Minimum in der Häufigkeitsverteilung und/oder die jeweils einem Mittelwert zwischen benachbarten Maxima in der Häufigkeitsverteilung entsprechen.

8. Verfahren nach Anspruch 7, wobei
- in einem ersten untergeordneten Modus des Lernmodus ein Ruhewert (I_{R}) durch Bestimmen eines Maximums (52) der Häufigkeitsverteilung (50) aller im ersten untergeordneten Modus gemessenen Werte der Ströme (I_{L}) und/oder Spannungen detektiert wird und/oder
- in einem zweiten untergeordneten Modus des Lernmodus ein erster Ereigniswert (I_{E1}) durch Bestimmen eines Maximums (56) der Häufigkeitsverteilung (54) aller im zweiten untergeordneten Modus gemessenen Werte der Ströme (I_{L}) und/oder Spannungen detektiert wird und/oder
- in einem dritten untergeordneten Modus des Lernmodus ein zweiter Ereigniswert (I_{E2}) durch Bestimmen eines Maximums (60) der Häufigkeitsverteilung (58) aller im dritten untergeordneten Modus gemessenen Werte der Ströme (I_{L}) und/oder Spannungen detektiert wird.

9. Verfahren nach Anspruch 8, wobei
- ein erster Schwellenwert (P₁) bestimmt wird, der einem Mittelwert aus dem Ruhewert (I_{R}) und dem ersten Ereigniswert (I_{E1}) entspricht und/oder
- ein zweiter Schwellenwert (P₂) bestimmt wird, der einem Mittelwert aus dem ersten Ereigniswert (I_{E1}) und dem zweiten Ereigniswert (I_{E2}) entspricht.

10. Verfahren nach Anspruch 9, wobei in einem Prüfmodus geprüft wird, ob
- alle im ersten untergeordneten Modus gemessenen Werte der Ströme (I_{L}) und/oder Spannungen unterhalb des ersten Schwellenwerts (P₁) und/oder alle im zweiten untergeordneten Modus gemessenen Werte der Ströme (I_{L}) und/oder Spannungen oberhalb des ersten Schwellenwerts (P₁) liegen und/oder
- alle im zweiten untergeordneten Modus gemessenen Werte der Ströme (I_{L}) und/oder Spannungen unterhalb des zweiten Schwellenwerts (P₂) und/oder alle im dritten untergeordneten Modus gemessenen Werte der Ströme (I_{L}) und/oder Spannungen oberhalb des zweiten Schwellenwerts (P₂) liegen.

11. Verfahren nach einem der vorhergehenden Ansprüche 7 bis 10, wobei
im Betriebsmodus intervallweise oder ständig Werte der Ströme (I_{L}) und/oder Spannungen im Speicher (41) gespeichert oder über die Schnittstelle (20) zum externen Speichern während des Betriebs automatisch und/oder durch manuelle Aufforderung im Betriebsmodus oder im Lernmodus bestimmt oder abgeändert werden.

12. Verfahren nach einem der vorhergehenden Ansprüche 7 bis 11, wobei
bei einer manuellen Aufforderung durch einen Benutzer zum Bestimmen oder Abändern des oder der Schwellenwerte (P₁, P₂) den oder die zum Bestimmen oder Abändern ermittelten Schwellenwerte (P₁, P₂) angezeigt oder über die Schnittstelle (20) zur Anzeigeeinrichtung (24) ausgegeben werden und/oder
über die Schnittstelle (20) oder Eingabemittel Benutzerbefehle entgegengenommen werden, um in Abhängigkeit der Befehle einen oder mehrere hinterlegte Schwellenwerte (P₁, P₂) durch Ersetzen mit dem oder den ermittelten Schwellenwerten abzuändern, einen, alle oder mehrere der Schwellenwerte (P₁, P₂) und/oder der hinterlegten Werte der Ströme (I_{L}) und/oder Spannungen zu löschen und/oder zwischen den Modi umzuschalten.

13. Brandmelder- und/oder Löschsteuerzentrale (12) mit einer Zustandsüberwachungseinheit (18) nach einem der Ansprüche 1 bis 6, insbesondere zur Ausführung eines Verfahrens nach einem der Ansprüche 7 bis 12.

14. Brandmeldesystem (10) mit einer Zustandsüberwachungseinheit (18) nach einem der Ansprüche 1 bis 6, einer Brandmelder- und/oder Löschsteuerzentrale (12), mit einem Stromkreis (14) und mehreren Teilnehmern (M₁ bis M_{N}), insbesondere zur Ausführung eines Verfahrens nach einem der Ansprüche 7 bis 12.

## Claims

1. A condition monitoring unit for a fire detection and/or extinguishing control unit (12), comprising:
- at least one current circuit connection (16) for connecting the condition monitoring unit (18) to at least one current circuit (14), wherein the current circuit (14) has at least one participant (M₁ - M_{N}) which detects an event,
- a measuring device (42) for measuring values of currents (I_{L}) and/or voltages at the current circuit connection (16),
- an analysis unit (43) in which one or more threshold values (P₁, P₂) can be stored, wherein
- the analysis unit (43) is designed to detect, in an operating mode at least, an event in which values of currents (I_{L}) and/or voltages measured by the measuring device (42) exceed or fall below the at least one threshold value (P₁, P₂),
- a memory unit (41) or an interface (20) for transmitting data to an external memory unit, wherein
- the condition monitoring unit (18) is designed to store values of the currents (I_{L}) and/or voltages measured by the measuring device (42) in the memory unit (41), in a learning mode at least, or to output the values via the interface (20) to the external memory unit and to determine or change the threshold values (P₁, P₂) depending on the stored values of the currents (I_{L}) and/or voltages, wherein
the condition monitoring unit (18) is designed to determine or change the threshold value(s) (P₁, P₂) depending on the stored values of the currents (I_{L}) and/or voltages, to determine a frequency distribution of the measured values of the currents (I_{L}) and/or voltages and to select for threshold value(s) (P₁, P₂) those values of the currents (I_{L}) and/or voltages which correspond respectively to a minimum in the frequency distribution and/or which correspond respectively to a mean value between adjacent maxima in the frequency distribution.

2. The condition monitoring unit according to claim 1, wherein the learning mode further comprises:
- a first subordinate mode which is designed to detect a quiescent value (I_{R}) by determining a maximum (52) in the frequency distribution (50) of all the values of the currents (I_{L}) and/or voltages measured in the first subordinate mode and/or
- a second subordinate mode which is designed to detect a first event value (I_{E1}) by determining a maximum (56) in the frequency distribution (54) of all values of the currents (I_{L}) and/or voltages measured in the second subordinate mode, and/or
- a third subordinate mode which is designed to detect a second event value (I_{E2}) by determining a maximum (60) in the frequency distribution (58) of all the values of the currents (I_{L}) and/or voltages recorded in the third subordinate mode.

3. The condition monitoring unit according to claim 2, wherein the condition monitoring unit (18) is designed
- to determine a first threshold value (P₁) equal to an arithmetical mean of the quiescent value (I_{R}) and the first event value (I_{E1}) and/or
- to determine a second threshold value (P₂) equal to an arithmetical mean of the first event value (I_{E1}) and the second event value (I_{E2}).

4. The condition monitoring unit according to claim 3, wherein the condition monitoring unit (18) includes a test mode for testing whether
- all the values of the currents (I_{L}) and/or voltages measured in the first subordinate mode are below the first threshold value (P₁) and/or all the values of the currents (I_{L}) and/or voltages measured in the second subordinate mode are above the first threshold value (P₁) and/or
- all the values of the currents (I_{L}) and/or voltages measured in the second subordinate mode are below the second threshold value (P₂) and/or all the values of the currents (I_{L}) and/or voltages measured in the third subordinate mode are above the second threshold value (P₂).

5. The condition monitoring unit according to any one of the preceding claims, wherein
the condition monitoring unit (18) is designed to store, in the memory unit (41), values of the currents (I_{L}) and/or voltages which are measured at intervals or continuously in the operating mode and/or to output the values via the interface (20) to the external memory unit and to determine or change the threshold value(s) (P₁, P₂) automatically during the operating mode and/or to allow the user to determine or change the values measured at intervals or continuously, when manually requested in the operating mode or in the learning mode.

6. The condition monitoring unit according to any one of the preceding claims, wherein
the condition monitoring unit (18) is designed to display, for the user, the threshold value(s) (P₁, P₂) calculated for the purpose of determining or changing, when manually requested by a user to determine or change the threshold value(s) (P₁, P₂), or to output them via an interface (20) for display, for example on a display device (24), and/or
to receive user commands via the interface (20) or input means (26) in order, depending on the commands, to change one or more stored threshold values (P₁, P₂) by replacing them with the calculated threshold value(s) (P₁, P₂), to delete one, all or a plurality of the threshold value(s) (P₁, P₂) and/or the stored values of the currents (I_{L}) and/or voltages, and/or to switch between the modes.

7. A method for determining at least one threshold value (P₁, P₂) for a condition monitoring unit (18) for a fire detection and/or extinguishing control unit (12), wherein values of currents (I_{L}) and/or voltages at at least one current circuit connection (16) of the condition monitoring unit (18) are measured by means of a measuring device (42), wherein,
in an operating mode at least, an event in which values of currents (I_{L}) and/or voltages measured by the measuring device (42) exceed or fall below the at least one threshold value (P₁, P₂) is detected by an analysis unit (43), wherein
the measured values of the currents (I_{L}) and/or voltages are stored in a memory unit (41), in a learning mode at least, or the values are outputted via an interface (20) to the external memory, and
at least one threshold value (P₁, P₂) is determined or changed depending on the stored values of the currents (I_{L}) and/or voltages, wherein a frequency distribution of the measured values of the currents (I_{L}) and/or voltages is determined in order to determine or change the threshold value(s) (P₁, P₂) depending on the stored values of the currents (I_{L}) and/or voltages, and the values of the currents (I_{L}) and/or voltages which correspond respectively to a minimum in the frequency distribution and/or which correspond respectively to a mean value between adjacent maxima in the frequency distribution are selected for threshold value(s) (P₁, P₂).

8. The method according to claim 7, wherein
- in a first subordinate mode of the learning mode, a quiescent value (I_{R}) is detected by determining a maximum (52) in the frequency distribution (50) of all the values of the currents (I_{L}) and/or voltages measured in the first subordinate mode and/or
- in a second subordinate mode of the learning mode, a first event value (I_{E1}) is detected by determining a maximum (56) in the frequency distribution (54) of all the values of the currents (I_{L}) and/or voltages measured in the second subordinate mode, and/or
- in a third subordinate mode of the learning mode, a second event value (I_{E2}) is detected by determining a maximum (60) in the frequency distribution (58) of all the values of the currents (I_{L}) and/or voltages measured in the third subordinate mode.

9. The method according to claim 8, wherein
- a first threshold value (P₁) is determined which is equal to an arithmetical mean of the quiescent value (I_{R}) and the first event value (I_{E1}) and/or
- a second threshold value (P₂) is determined which is equal to an arithmetical mean of the first event value (I_{E1}) and the second event value (I_{E2}).

10. The method according to claim 9, wherein tests are performed in a test mode to determine whether
- all the values of the currents (I_{L}) and/or voltages measured in the first subordinate mode are below the first threshold value (P₁) and/or all the values of the currents (I_{L}) and/or voltages measured in the second subordinate mode are above the first threshold value (P₁) and/or
- all the values of the currents (I_{L}) and/or voltages measured in the second subordinate mode are below the second threshold value (P₂) and/or all the values of the currents (I_{L}) and/or voltages measured in the third subordinate mode are above the second threshold value (P₂).

11. The method according to any one of the claims 7 to 10, wherein
in the operating mode, values of the currents (I_{L}) and/or voltages are stored at intervals or continuously in the memory unit (41), or are automatically outputted via the interface (20) to the external memory unit during operation, and/or are determined or changed by manual request in the operating mode or in the learning mode.

12. The method according to any one of the claims 7 to 11, wherein
when a user manually requests to determine or change the threshold value(s) (P₁, P₂), the threshold value(s) (P₁, P₂) calculated for the purpose of determining or changing are displayed or outputted via an interface (20) to the display device (24) and/or
user commands are received via the interface (20) or input means in order, depending on the commands, to change one or more stored threshold values (P₁, P₂) by replacing them with the calculated threshold values (P₁, P₂), to delete one, all or a plurality of the threshold value(s) (P₁, P₂) and/or the stored values of the currents (I_{L}) and/or voltages, and/or to switch between the modes.

13. A fire detection and/or extinguishing control unit (12) comprising a condition monitoring unit (18) according to any one of claims 1 to 6, in particular for carrying out a method according to any one of claims 7 to 12.

14. A fire detection system (10) comprising a condition monitoring unit (18) according to any one of claims 1 to 6, a fire detection and/or extinguishing control unit (12), comprising a current circuit (14) and several participants (M₁ - M_{N}), in particular for carrying out a method according to any one of claims 7 to 12.

## Revendications

1. Unité de surveillance d'état pour une centrale d'alarme d'incendie et/ou de commande d'extinction (12), comprenant :
- au moins un raccord de circuit électrique (16) destiné à raccorder l'unité de surveillance d'état (18) à au moins un circuit électrique (14), dans laquelle le circuit électrique (14) présente au moins un abonné (M₁ à M_{N}) détectant des événements,
- un dispositif de mesure (42) destiné à mesurer des valeurs de courants (I_{L}) et/ou de tensions sur le raccord de circuit électrique (16),
- une unité d'évaluation (43), dans laquelle une ou plusieurs valeurs de seuil (P₁, P₂) peuvent être mémorisées, dans laquelle
- l'unité d'évaluation (43) est mise au point pour détecter au moins dans un mode de fonctionnement un événement lors du dépassement ou du non-dépassement de l'au moins une valeur de seuil (P₁, P₂) par des valeurs, mesurées avec le dispositif de mesure (42), de courants (I_{L}) et/ou de tensions,
- une mémoire (41) ou une interface (20) destinée à transférer des données à une mémoire externe, dans laquelle
- l'unité de surveillance d'état (18) est mise au point pour stocker dans la mémoire (41) au moins dans un mode d'apprentissage des valeurs, mesurées avec le dispositif de mesure (42), des courants (I_{L}) et/ou des tensions ou les envoyer à la mémoire externe par l'intermédiaire de l'interface (20) et pour définir ou modifier la ou les valeurs de seuil (P₁, P₂) en fonction des valeurs stockées des courants (I_{L}) et/ou des tensions, dans laquelle
l'unité de surveillance d'état (18) est mise au point pour définir ou modifier la ou les valeurs de seuil (P₁, P₂) en fonction des valeurs enregistrées des courants (I_{L}) et/ou des tensions, pour définir une distribution de fréquences des valeurs mesurées des courants (I_{L}) et/ou des tensions et pour choisir pour la ou les valeurs de seuil (P₁, P₂) les valeurs des courants (I_{L}) et/ou des tensions qui correspondent respectivement à une minimale dans la distribution de fréquences et/ou qui correspondent respectivement à une valeur moyenne entre des maximales adjacentes dans la distribution de fréquences.

2. Unité de surveillance d'état selon la revendication 1, dans laquelle le mode d'apprentissage comprend en outre :
- un premier mode subordonné, qui est mis au point pour détecter une valeur au repos (I_{R}) en définissant une maximale (52) de la distribution de fréquences (50) de toutes les valeurs, mesurées dans le premier mode subordonné, des courants (I_{L}) et/ou des tensions, et/ou
- un deuxième mode subordonné, qui est mis au point pour détecter une première valeur d'événement (I_{E1}) en définissant une maximale (56) de la distribution de fréquences (54) de toutes les valeurs, mesurées dans le deuxième mode subordonné, des courants (I_{L}) et/ou des tensions, et/ou
- un troisième mode subordonné, qui est mis au point pour détecter une deuxième valeur d'événement (I_{E2}) en définissant une maximale (60) de la distribution de fréquences (58) de toutes les valeurs, relevées dans le troisième mode subordonné, des courants (I_{L}) et/ou des tensions.

3. Unité de surveillance d'état selon la revendication 2, dans laquelle l'unité de surveillance d'état (18) est mise au point
- pour définir une première valeur de seuil (P₁), qui correspond à une valeur moyenne issue de la valeur au repos (I_{R}) et de la première valeur d'événement (I_{E1}), et/ou
- pour définir une deuxième valeur de seuil (P₂), qui correspond à une valeur moyenne issue de la première valeur d'événement (I_{E1}) et de la deuxième valeur d'événement (I_{E2}).

4. Unité de surveillance d'état selon la revendication 3, dans laquelle l'unité de surveillance d'état (18) comprend un mode de vérification pour vérifier si
- toutes les valeurs, mesurées dans le premier mode subordonné, des courants (I_{L}) et/ou des tensions sont inférieures à la première valeur de seuil (P₁) et/ou toutes les valeurs, mesurées dans le deuxième mode subordonné, des courants (I_{L}) et/ou des tensions sont supérieures à la première valeur de seuil (P₁), et/ou
- toutes les valeurs, mesurées dans le deuxième mode subordonné, des courants (I_{L}) et/ou des tensions sont inférieures à la deuxième valeur de seuil (P₂) et/ou toutes les valeurs, mesurées dans le troisième mode subordonné, des courants (I_{L}) et/ou des tensions sont supérieures à la deuxième valeur de seuil (P₂).

5. Unité de surveillance d'état selon l'une quelconque des revendications précédentes, dans laquelle
l'unité de surveillance d'état (18) est mise au point pour mémoriser dans la mémoire (41) des valeurs, mesurées dans le mode de fonctionnement par intervalle ou en permanence, des courants (I_{L}) et/ou des tensions et/ou pour les envoyer à la mémoire externe par l'intermédiaire de l'interface (20) et pour définir ou modifier la ou les valeurs de seuil (P₁, P₂) automatiquement pendant le mode de fonctionnement et/ou pour définir ou modifier par un utilisateur les valeurs mesurées par intervalle ou en permanence sur demande manuelle dans le mode de fonctionnement ou dans le mode d'apprentissage.

6. Unité de surveillance d'état selon l'une quelconque des revendications précédentes, dans laquelle
l'unité de surveillance d'état (18) est mise au point pour afficher à l'utilisateur la ou les valeurs de seuil (P₁, P₂) déterminées pour la définition ou la modification lors d'une demande manuelle par un utilisateur pour définir ou modifier la ou les valeurs de seuil (P₁, P₂) ou les envoyer par l'intermédiaire d'une interface (20) pour l'affichage, par exemple sur un dispositif d'affichage (24), et/ou
pour réceptionner par l'intermédiaire de l'interface (20) ou de moyens d'entrée (26) des instructions d'utilisateur pour modifier, en fonction des instructions, une ou plusieurs valeurs de seuil (P₁, P₂) enregistrées par remplacement avec la ou les valeurs de seuil (P₁, P₂) déterminées, pour supprimer une, la totalité ou plusieurs des valeurs de seuil (P₁, P₂) et/ou des valeurs enregistrées des courants (I_{L}) et/ou des tensions et/ou pour commuter entre les modes.

7. Procédé de définition d'au moins une valeur de seuil (P₁, P₂) pour une unité de surveillance d'état (18) pour une centrale d'alarme incendie et/ou de commande d'extinction (12), dans lequel des valeurs de courants (I_{L}) et/ou de tensions sont mesurées sur au moins un raccord de circuit électrique (16) de l'unité de surveillance d'état (18) avec un dispositif de mesure (42), dans lequel
un événement est détecté, lors du dépassement ou du non-dépassement d'au moins une valeur de seuil (P₁, P₂) par des valeurs, mesurées avec le dispositif de mesure (42), de courants (I_{L}) et/ou de tensions avec une unité d'évaluation (43) au moins dans un mode de fonctionnement,
dans lequel
les valeurs mesurées des courants (I_{L}) et/ou des tensions sont mémorisées dans une mémoire (41) au moins dans un mode d'apprentissage ou sont envoyées à la mémoire externe par l'intermédiaire d'une interface (20), et
au moins une valeur de seuil (P₁, P₂) est définie ou modifiée en fonction des valeurs enregistrées des courants (I_{L}) et/ou des tensions, dans lequel, pour définir ou modifier la ou les valeurs de seuil (P₁, P₂) en fonction des valeurs enregistrées des courants (I_{L}) et/ou des tensions, une distribution de fréquences des valeurs mesurées des courants (I_{L}) et/ou des tensions est définie et les valeurs des courants (I_{L}) et/ou des tensions sont choisies pour la ou les valeurs de seuil (P₁, P₂), qui correspondant respectivement à une minimale dans la distribution de fréquences et qui correspondent respectivement à une valeur moyenne entre des maximales adjacentes dans la distribution de fréquences.

8. Procédé selon la revendication 7, dans lequel
- dans un premier mode subordonné du mode d'apprentissage, une valeur au repos (I_{R}) est détectée en définissant une maximale (52) de la distribution de fréquences (50) de toutes les valeurs, mesurées dans le premier mode subordonné, des courants (I_{L}) et/ou des tensions, et/ou
- dans un deuxième mode subordonné du mode d'apprentissage, une première valeur d'événement (I_{E1}) est détectée en définissant une maximale (56) de la distribution de fréquences (54) de toutes les valeurs, mesurées dans le deuxième mode subordonné, des courants (I_{L}) et/ou des tensions, et/ou
- dans un troisième mode subordonné du mode d'apprentissage, une deuxième valeur d'événement (I_{E2}) est détectée en définissant une maximale (60) de la distribution de fréquences (58) de toutes les valeurs, mesurées dans le troisième mode subordonné, des courants (I_{L}) et/ou des tensions.

9. Procédé selon la revendication 8, dans lequel
- une première valeur de seuil (P₁) est définie, qui correspond à une valeur moyenne issue de la valeur au repos (I_{R}) et de la première valeur d'événement (I_{E1}), et/ou
- une deuxième valeur de seuil (P₂) est définie, qui correspond à une valeur moyenne issue de la première valeur d'événement (I_{E1}) et de la deuxième valeur d'événement (I_{E2}).

10. Procédé selon la revendication 9, dans lequel il est vérifié dans un mode de vérification si
- toutes les valeurs, mesurées dans le premier mode subordonné, des courants (I_{L}) et/ou des tensions sont inférieures à la première valeur de seuil (P₁) et/ou toutes les valeurs, mesurées dans le deuxième mode subordonné, des courants (I_{L}) et/ou des tensions sont supérieures à la première valeur de seuil (P₁), et/ou
- toutes les valeurs, mesurées dans le deuxième mode subordonné, des courants (I_{L}) et/ou des tensions sont inférieures à la deuxième valeur de seuil (P₂) et/ou toutes les valeurs, mesurées dans le troisième mode subordonné, des courants (I_{L}) et/ou des tensions sont supérieures à la deuxième valeur de seuil (P₂).

11. Procédé selon l'une quelconque des revendications précédentes 7 à 10, dans lequel
dans le mode de fonctionnement, des valeurs des courants (I_{L}) et/ou des tensions sont mémorisées dans la mémoire (41) par intervalle ou de manière permanente ou sont définies ou modifiées par l'intermédiaire de l'interface (20) pour le stockage externe pendant le fonctionnement automatiquement et/ou sur demande manuelle dans le mode de fonctionnement ou dans le mode d'apprentissage.

12. Procédé selon l'une quelconque des revendications précédentes 7 à 11, dans lequel
dans une demande manuelle par un utilisateur pour définir ou modifier la ou les valeurs de seuil (P₁, P₂), la ou les valeurs de seuil (P₁, P₂) déterminées pour la définition ou la modification sont affichées ou sont envoyées au dispositif d'affichage (24) par l'intermédiaire de l'interface (20), et/ou
des instructions d'utilisateur sont réceptionnées par l'intermédiaire de l'interface (20) ou de moyens d'entrée pour modifier, en fonction des instructions, une ou plusieurs valeurs de seuil (P₁, P₂) enregistrées par le remplacement avec la ou les valeurs de seuil déterminées, pour supprimer une, la totalité ou plusieurs des valeurs de seuil (P₁, P₂) et/ou des valeurs enregistrées des courants (I_{L}) et/ou des tensions et/ou pour commuter entre les modes.

13. Centrale d'alarme incendie et/ou de commande d'extinction (12) avec une unité de surveillance d'état (18) selon l'une quelconque des revendications 1 à 6, en particulier pour exécuter un procédé selon l'une quelconque des revendications 7 à 12.

14. Système d'alarme incendie (10) avec une unité de surveillance d'état (18) selon l'une quelconque des revendications 1 à 6, une centrale d'alarme incendie et/ou de commande d'extinction (12), avec un circuit électrique (14) et plusieurs abonnés (M₁ à M_{N}) en particulier pour exécuter un procédé selon l'une quelconque des revendications 7 à 12.
